# EUROPEAN PATENT APPLICATION

(11) **EP 4 844 483 A1**
(43) Date of publication of application: **25.11.2026**
(21) Application number: 25178626.5
(22) Date of filing: 23.05.2025
(51) Int. Cl.: G03F 1/62, G03F 7/20

(54) **METHOD OF PELLICLE MEASUREMENT, COMPUTER PROGRAM FOR PELLICLE MEASUREMENT AND PELLICLE**

(71) Applicant: ASML Netherlands B.V., 5500 AH Veldhoven (NL)
(72) Inventor: DREISSEN, Mante, 5500 AH Veldhoven (NL); REIJNDERS, Marinus, Petrus, 5500 AH Veldhoven (NL); CARBONE, Ludovico, 5500 AH Veldhoven (NL)
(74) Representative: ASML Netherlands B.V.

(57) **Abstract**

A method of measuring a pellicle mounted on a reticle in a lithographic apparatus, the method comprising:
directing radiation through a measurement portion of the pellicle to a reflective portion of the reticle and measuring the intensity of reflected radiation to obtain a first detection intensity;
directing radiation through a reference portion of the pellicle to a reflective portion of the reticle and measuring the intensity of reflected radiation to obtain a second detection intensity; and
comparing the first and second detection intensities to obtain a measurement of a property of the pellicle;
wherein the reference portion but not the measurement portion is protected against a cause of degradation of the pellicle.

## Description

### FIELD

The present invention relates to techniques of measuring a pellicle, in particular measuring the transmission of a pellicle, and to pellicles adapted to facilitate measurements.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as "Moore's law". To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm.

A lithographic apparatus may include an illumination system for providing a projection beam of radiation, and a support structure for supporting a patterning device. The patterning device may serve to impart the projection beam with a pattern in its cross-section. The apparatus may also include a projection system for projecting the patterned beam onto a target portion of a substrate.

Contaminant particles may be generated during exposure. If these particles are allowed to reach, and be deposited on, the patterning device, they may cast an image on the substrate, leading to defects in the substrate. As feature size continues to shrink, it becomes increasingly important to prevent such defects from forming. For this purpose, it is common to cover the patterning device with a pellicle, which is an optically transmissive membrane. Pellicles, however, may not have a stable transmission, leading to dose errors (i.e. exposure of a die with incorrect amount of radiation).

### SUMMARY OF THE INVENTION

Therefore, an object of the present invention is to provide a method of measuring properties of a pellicle, for example its transmission, and a pellicle that is adapted to facilitate such measurements.

In accordance with the present invention, there is disclosed a method of measuring a pellicle mounted on a reticle in a lithographic apparatus, the method comprising:
directing radiation through a measurement portion of the pellicle to a reflective portion of the reticle and measuring the intensity of reflected radiation to obtain a first detection intensity;
directing radiation through a reference portion of the pellicle to a reflective portion of the reticle and measuring the intensity of reflected radiation to obtain a second detection intensity; and
comparing the first and second detection intensities to obtain a measurement of a property of the pellicle;
wherein the reference portion but not the measurement portion is protected against a cause of degradation of the pellicle.

In accordance with the present invention, there is disclosed a method of manufacturing devices comprising:
measuring a property of a pellicle according to the method of any one of the preceding clauses; and
controlling a dose of an exposure based on the measurement of a property.

In accordance with the present invention, there is disclosed a pellicle for use in a lithographic apparatus, the pellicle comprising a measurement portion and a reference portion, wherein the reference portion but not the measurement portion is protected against a cause of degradation of the pellicle.

### BRIEF DESCRIPTION OF THE DRAWINGS

Embodiments of the invention will now be described, by way of example only, with reference to the accompanying schematic drawings, in which corresponding reference symbols indicate corresponding parts.
Figure 1 schematically depicts a lithographic apparatus.
Figure 2A schematically depicts light from a patterning device alignment mark passing through a pellicle.
Figure 2B schematically depicts light from a patterning device stage alignment mark not passing through the pellicle.
Figure 3 is a graph of transmission of a pellicle against number of uses.
Figure 4 schematically depicts in plan an arrangements of reference marks and a pellicle in accordance with an embodiment.
Figure 5 schematically depicts in section an arrangements of reference marks and a pellicle in accordance with an embodiment.
Figure 6 schematically depicts the arrangement of reference marks and the pellicle of Figure 5 after use.
Figure 7 schematically depicts in plan an arrangements of reference marks and a pellicle in accordance with an embodiment.
Figure 8 schematically depicts in plan an arrangements of reference marks and a pellicle in accordance with an embodiment..
Figure 9 is a graph depicting transmission of a protective coating with wavelength

### DETAILED DESCRIPTION

In the present document, the terms "radiation" and "beam" are used to encompass all types of electromagnetic radiation, including ultraviolet radiation (e.g., with a wavelength of 436, 405, 365, 248, 193, 157, 126 or 13.5 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

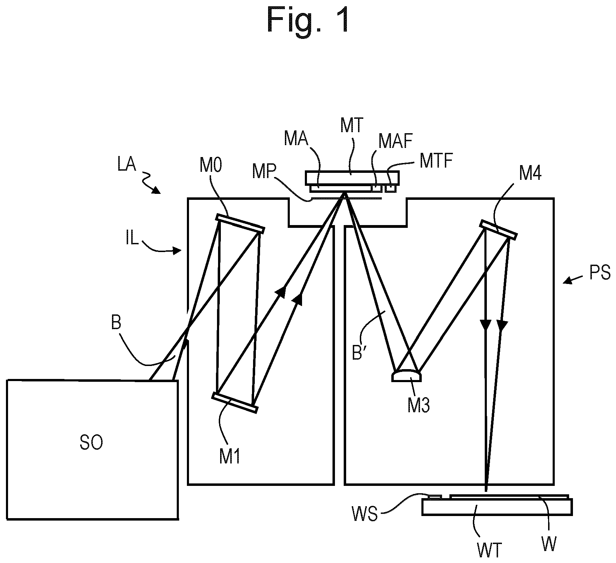

Figure 1 schematically depicts a lithographic apparatus LA. The lithographic apparatus LA includes an illumination system (also referred to as illuminator) IL configured to condition a radiation beam B (e.g., EUV radiation or DUV radiation), a patterning device stage or mask support (e.g., a mask table) MT constructed to support a patterning device (e.g., a mask) MA and connected to a first positioner PM configured to accurately position the patterning device MA in accordance with certain parameters, a substrate support (e.g., a substrate table or a substrate holder) WT constructed to hold a substrate (e.g., a resist coated wafer) W and connected to a second positioner PW configured to accurately position the substrate support WT in accordance with certain parameters, and a projection system (e.g., a refractive projection lens system or a reflective optics system) PS configured to project a pattern imparted to the radiation beam B by patterning device MA onto a target portion C (e.g., comprising one or more dies) of the substrate W.

In operation, the illumination system IL receives the radiation beam B from a radiation source SO, e.g., via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate W may be covered by an immersion liquid having a relatively high refractive index, e.g., water, so as to fill an immersion space between the projection system PS and the substrate W - which is also referred to as immersion lithography. More information on immersion techniques is given in US 6,952,253, which is incorporated herein by reference.

The lithographic apparatus LA may be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage (not depicted in Figure 1). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus LA, for example a part of the projection system PS or a part of a system that provides the immersion liquid. The measurement stage may move beneath the projection system PS when the substrate support WT is away from the projection system PS.

In operation, the radiation beam B is incident on the patterning device, e.g., mask, MA which is held on the patterning device stage MT, and is patterned by the pattern (design layout) present on patterning device MA. Having traversed the mask MA, the radiation beam B passes through the projection system PS, which focuses the beam onto a target portion C of the substrate W. With the aid of the second positioner and a position measurement system, the substrate support WT can be moved accurately, e.g., so as to position different target portions in the path of the radiation beam B at a focused and aligned position. Similarly, the first positioner and possibly another position sensor (which is not explicitly depicted in Figure 1) may be used to accurately position the patterning device MA with respect to the path of the radiation beam B. Patterning device MA and substrate W may be aligned using patterning device alignment mark MAF and substrate alignment marks. Although the substrate alignment marks occupy dedicated target portions, they may be located in spaces between target portions. Substrate alignment marks are known as scribe-lane alignment marks when these are located between the target portions.

In this specification, a Cartesian coordinate system is used. The Cartesian coordinate system has three axis, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

As noted above, the lithographic apparatus LA may be used to expose portions of a substrate W in order to form a pattern in the substrate W. In order to improve the accuracy with which a desired pattern is transferred to a substrate W, properties such as the alignment of the patterning device MA and/or the patterning device stage MT may be measured. Such alignments may include relative alignments, including the relative alignment between the patterning device MA and the patterning device stage MT, the relative alignment between the patterning device MA and the substrate support WT, and/or the relative alignment between the patterning device stage MT and the substrate support WT. These properties may be measured on a regular basis, often before exposure of each substrate W, and/or also after exposure of each substrate W, or may be measured less frequently, for example, as part of a calibration process.

Determining the relative alignment of the patterning device stage MT and the substrate support WT assists in projecting a patterned radiation beam onto a desired portion of a substrate W. This may be particularly important when projecting patterned radiation onto a substrate W which includes portions which have already been exposed to radiation, so as to improve alignment of the patterned radiation with the previously exposed regions.

The alignment measurements described above may be performed by illuminating an alignment mark MAF fixedly provided on the patterning device MA, and/or an alignment mark MTF fixedly provided on the patterning device stage MT as required. The image produced by the alignment marks may be captured by an optical system, such as an alignment sensor WS.

The patterning device alignment mark MAF and the stage alignment mark MTF may each have a reflective geometric pattern. Different geometric patterns may be suitable for different directions or fineness of alignments. Suitable geometric patterns include: a solid square or rectangle, pinhole features, diffraction gratings, and a chequerboard pattern, for example. Furthermore, more than one alignment mark may be provided on each of the patterning device MA and the patterning device stage MT. It should also be understood that marks for other purposes than alignment (such as marks for aberration detection) may also be present.

As shown in Figure 1, the patterning device alignment mark MAF may form part of a patterning device MA. One or more such alignment mark MAF may be provided on patterning devices MA used to perform lithographic exposures. An alignment mark MAF may be positioned outside of a patterned region of the patterning device MA, which is illuminated with radiation during a lithographic exposure. As noted above, multiple alignment marks MAF, MTF may be provided on each of the patterning device MA and the patterning device stage MT. An alignment operation may make use of one, several, or all of these alignment marks MAF, MTF. For example, each of the alignment marks MAF, MTF may comprise a dedicated piece of hardware, sometimes referred to as a "fiducial". In some implementations, the patterning device alignment mark MAF may be etched directly into the patterning device MA, alongside the patterned region of the patterning device MA. For the purposes of this description, a fiducial is considered to be an example of an alignment mark.

As shown in Figure 1, the lithographic apparatus LA may be an EUV lithographic apparatus and therefore uses a reflective patterning device MA. The patterning device alignment mark MAF may thus be of the reflective type. In other lithography technologies, the patterning device MA may be transmissive, and the patterning device alignment mark MAF may accordingly also be transmissive. It should be understood that the present invention can be implemented with either reflective or transmissive alignment marks, depending on the lithography technology employed.

In order to measure alignment of the patterning device MA and the patterning device stage MT, an alignment sensor WS (as shown schematically in Figure 1) may be provided to measure light B' which is output from the projection system PS. The alignment sensor WS may, for example, be provided on or attached to the substrate support WT as shown in Figure 1. In order to perform an alignment process, the patterning device stage MT may be positioned such that the stage alignment mark MTF is illuminated with light B from the illumination system IL and the image of the stage alignment mark MTF is measured by the alignment sensor WS; and, separately, the patterning device stage MT may be positioned such that the patterning device alignment mark MAF is illuminated with light B from the illumination system IL and the image of the patterning device alignment mark MAF is measured by the alignment sensor WS. The substrate support WT may be positioned such that radiation which is reflected from the alignment marks MAF, MTF is projected, by the projection system PS, onto the alignment sensor WS.

The position of the alignment feature in the radiation beam B may be measured by an alignment sensor WS positioned at a substrate W level (e.g. provided on or attached to the substrate support WT as shown in Figure 1). The alignment sensor WS may be operable to detect the position of an alignment feature in the radiation incident upon it. This may allow the alignment of the substrate support WT relative to the stage alignment mark MTF and/or the patterning device alignment mark MAF to be determined. With knowledge of the relative alignment of the patterning device MA, and/or the patterning device stage MT, and/or the substrate support WT, the patterning device MA and the substrate support WT may be moved relative to each other so as to form a pattern (using the patterned radiation beam B' reflected from the patterning device MA) at a desired location on the substrate W. The position of the substrate W on the substrate support WT may be determined using a separate measurement process.

During exposure cycles, various contaminant particles may be generated. These particles, if allowed to reach, and be deposited on, the patterning device MA may contaminate the patterning device MA. Such contamination may cause the pattern on the patterning device MA to be indirectly reproduced on the wafer W, leading to defects. Therefore, it is common for the operator of the lithographic apparatus LA to use a pellicle MP to protect the patterning device MA. Typically, the pellicle is a membrane which is optically transmissive to the light beam B. As shown in Figure 1, the pellicle MP may be provided just in front of the patterning device MA. The pellicle MP may be spaced away from the patterning device MA by a distance. This may prevent the image of any contaminants present on the pellicle MP from being reproduced on the substrate W. The distance between the pellicle MP and the surface of the patterning device MA may be about 1 mm, for example. The pellicle MP itself may have a thickness in the tens of nanometers. Generally, the pellicle MP is not 100% transmissive to the light B. A high level of transmission is generally desired for high illumination efficiency. Typically, the transmission of the pellicle MP may be within the range of 75% to 98%.

Pellicles MP generally have a limited life span, and may rupture after a certain number of exposure cycles. When the pellicle MP ruptures, in some cases the pellicle MP may pulverize and generate a large amount of contaminant particles, which may flow to different parts of the lithographic apparatus LA. This may result, at best, defects in the exposed substrate W and, at worst, damage to components of the lithographic apparatus LA. Also, exposures performed after rupture of a pellicle may have incorrect exposure doses. Therefore, in the event of rupture of the pellicle MP, it may be desirable to halt the lithographic apparatus LA as soon as possible. The surfaces of components within the lithographic apparatus LA may need to be cleaned and the components of the lithographic apparatus LA may need to be repaired or replaced. Therefore, it may be desirable to detect whether the pellicle MP is present and intact, or has ruptured, so that the lithographic apparatus can be halted if necessary. Additionally or alternatively, it may be desirable to monitor the remaining life of the pellicle MP, so that the pellicle MP may be replaced before the risk of rupture becomes too high.

It is possible to use the alignment sensor WS described above to detect the presence or absence of the pellicle MP as well as performing alignment operations. Furthermore, by using the alignment sensor WS, it may be possible to determine the presence of absence of the pellicle MP at the same time as performing alignment operations.

As shown in Figure 1, the pellicle MP may be positioned to cover the patterning device MA and the patterning device alignment mark MAF, but may leave the stage alignment mark MTF uncovered. As a result, light B' from the patterning device alignment mark MAF will pass through the pellicle MP (if present) before reaching the alignment sensor WS, whereas light from the stage alignment mark MTF will not pass through the pellicle MP (even if one is present) before reaching the alignment sensor WS. In other words, the pellicle MP may be positioned such that the pellicle MP intersects a light path between the alignment sensor WS and the patterning device MA. More specifically, the pellicle MP may be positioned such that the pellicle MP intersects the light path between the alignment sensor WS and the patterning device alignment mark MAF. Furthermore, the pellicle MP may be positioned such that the pellicle MP does not intersect the light path between the alignment sensor WS and the stage alignment mark MTF. Similarly, in embodiments where the patterning device MA is of the reflective type, light beam B from the illumination system IL would pass through the pellicle MP (if present and intact) before reaching the patterning device alignment mark MAF, but would not pass through the pellicle MP (even if one is present) before reaching the stage alignment mark MTF.

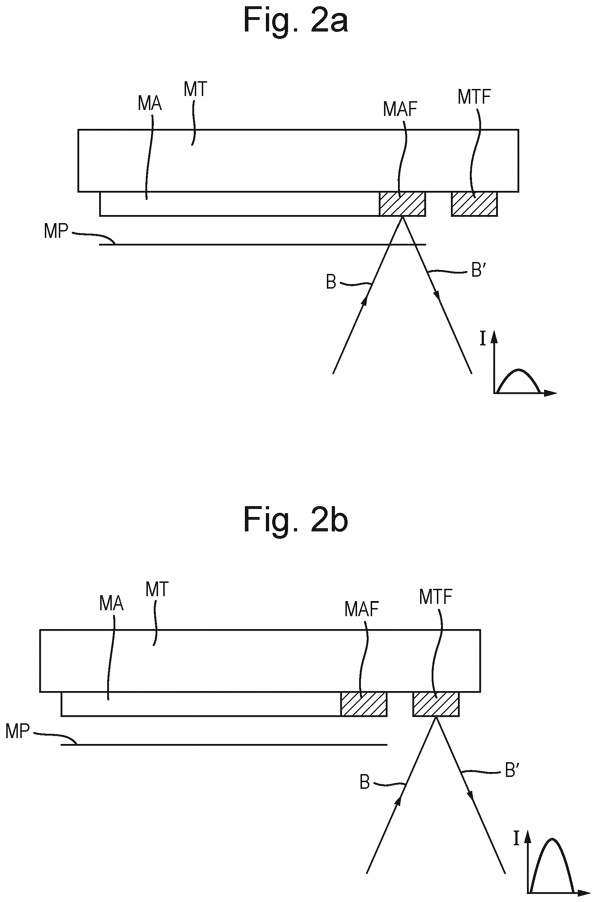

The fact that the pellicle MP (if present) covers the patterning device alignment mark MAF but not the stage alignment mark MTF may enable using the alignment sensor WS to provide the additional functionality of detecting pellicle MP presence. As shown in Figure 2A, when the patterning device stage MT is positioned so that the patterning device alignment mark MAF is exposed to light B from the illumination system IL, if the pellicle MP is present and intact, the light B' from the patterning device alignment mark MAF will pass through the pellicle MP. In case the patterning device MA is of the reflective type, such as shown in Figure 2A, the light B from the illumination system IL will also pass through the pellicle MP before reaching the patterning device alignment mark MAF. Therefore, in case the patterning device MA is of the reflective type, light B from the illumination system IL will pass through the pellicle twice before reaching the alignment sensor WS. In either case, whether the light B passes through the pellicle MP once (in case of a transmissive patterning device MA) or twice (in case of a reflective patterning device MA), the reflected light B' will be attenuated somewhat by the pellicle MP. As a result, as shown in Figure 2A, the intensity of the light B' detected by the alignment sensor WS may be relatively low.

By contrast, as shown in Figure 2B, when the patterning device stage MT has displaced to a position such that the stage alignment mark MTF is exposed to light B from the illumination system IL, the light B reaches and leaves the stage alignment mark MTF without passing through the pellicle MP. As a result, the intensity of the light B' detected by the alignment sensor WS may be relatively high.

If the pellicle is absent or has ruptured, the light B from the illumination system IL would reach and leave the patterning device alignment mark MAF without passing through any pellicle. As a result, the intensity of the light B' detected by the alignment sensor WS may be relatively high, and may be comparable to the intensity of light B' from the stage alignment mark MTF.

In other words, if the pellicle MP is present and intact, it can be expected that the alignment sensor WS will measure a lower intensity of light B' form the patterning device alignment mark MAF compared with light B' reflected from the stage alignment mark MTF. If the pellicle MP is absent or has ruptured, it can be expected that the alignment sensor WS will measure a comparable intensity of light B' from the patterning device alignment mark MAF and from the stage alignment mark MTF.

Therefore, a method of pellicle MP detection comprises using the alignment sensor, measuring a first detection intensity; using the alignment sensor, measuring a second detection intensity, being the intensity of light reflected from the patterning device; and comparing the first and second detection intensities. By comparing the first and second detection intensities, it is possible to detect whether the pellicle MP is present and intact, or is absent or has ruptured.

More specifically, the pellicle MP may be monitored using the stage alignment mark MTF and the patterning device alignment mark MAF. In this case, the first detection intensity, *I_{fid},* may be the intensity of light reflected from the stage alignment mark, and the second detection intensity, *Iᵣₑₜ*, may be the intensity of light reflected from the patterning device alignment mark.

In order to selectively expose the patterning device alignment mark MAF and the stage alignment mark MTF, the relative position between the light beam B and the patterning device stage MT may be adjusted. That is, when measuring the first detection intensity, the relative position may be adjusted so that at least a portion of the light beam B is incident on the stage alignment mark MTF, the reflection of which being measured as the first detection intensity. When measuring the second detection intensity, the relative position may be adjusted so that at least a portion of the light beam B is incident on the patterning device alignment mark MAF, the reflection of which being measured as the second detection intensity, and the portion of the light beam passes through the pellicle in case the pellicle is present.

As with any real-life system, the first and second intensities can be affected by many different factors. A detailed mathematical model can be established to estimate what the first and second detection intensities would be when the pellicle MP is present or absent. Of course, the more these factors are accounted for, the better the reliability of the pellicle monitoring or detection can be. It should be noted, however, that many of these factors can be simplified or neglected, and pellicle monitoring or detection can still be successfully performed by comparing the first and second detection intensities. Some of these factors may be accounted for depending on the level of reliability desired. Furthermore, many of these factors can be reduced to, or approximated as, constants provided that successive measurements are performed under the same conditions (e.g. using the same settings, performed at the same or similar location, and performed at the same or similar time).

With certain types of pellicle material, the pellicle MP may become increasingly transmissive to the radiation beam B and B' as the number of exposures increases. Different mechanisms may lead to the increase in transmission. For example, the pellicle MP material may become thinner due to repeated exposure to the radiation beam B. That is, the radiation beam B may etch away some of the material of the pellicle MP at each exposure. Alternatively or additionally, the material of the pellicle MP may become less dense due to repeated exposure to the radiation beam B, leading to increased transmission. The pellicle MP may become more transmissive due to exposure to the radiation beam B in the presence of hydrogen.

For example, the pellicle MP may be made of a multilayer film, a composite film, or a fibrous material. The multilayer film may comprise layers of Si, Mo, Ru, ZrO2, etc.. The composite film may comprise crystalline material (e.g. metal silicide crystals such as MoSix, ZrSix, etc.) in an amorphous matrix (such as Si, SiNx, SiC, S, etc.). The fibrous material may be nanotubes such as carbon nanotubes (CNT), silicon nanotubes (SiNT) or boron nitride nanotubes (BNNT). For simplicity, when referring herein to carbon nanotubes, it is to be understand that any kind of films, including films comprising nanotubes and mixtures thereof in a film, are also encompassed.

Carbon nanotubes may be a desirable material choice for pellicles MP because it is able to withstand high intensities of EUV radiation. CNT pellicles MP may exhibit increasing transmission as the number of exposures increases. This may be due to etching by the radiation beam B, leading to reducing thickness over time. Alternatively or additionally, the carbon nanotubes may shrink due to exposure to the radiation beam B, leading to increased transmission. In particular, the wall thickness of the carbon nanotubes may shrink. The carbon nanotubes may shrink without substantially affecting the thickness of the pellicle MP. In essence, CNT pellicles MP may have a porous structure, and may become optically less dense due to repeated exposure to the radiation beam B.

By way of an example only, a typical CNT pellicle MP may have a transmission of around 90% to 96%, typically greater than 95%, when brand new, which may increase after use to 98% or more.

The principles of the invention as described below may also be applied, mutatis mutandis, to pellicle types where transmission decreases with time.

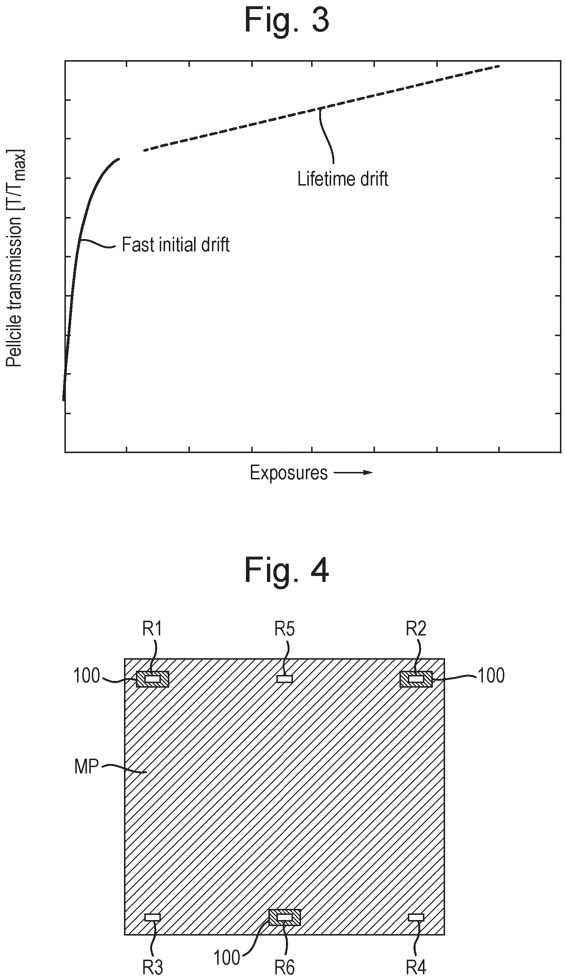

Figure 3 depicts transmission of a pellicle to EUV radiation against the number of exposures that the pellicle, and mask to which it has been attached, has been used to perform. The inventors have noted that the observed change in transmission can be described as a fast initial drift followed by a slow lifetime drift. Without being bound by any specific theory, it is believed that the fast initial drift is caused by desorption of water (or other contaminants) that have absorbed onto the pellicle when exposed to air but desorb when the pellicle is heated by the exposure radiation in vacuum.

It is observed that after the fast initial drift, the relationship between the number of exposures and the transmission of the pellicle MP may be approximately linear. This is particularly true of CNT pellicles MP. As the pellicle MP can be expected to degrade gradually, the transmission value of the pellicle MP may also be expected to increase gradually. Nevertheless, as with any real-world measurements, the input data may comprise unexpected fluctuations such as measurement noise. Without being bound by any specific theory, it is believed that the lifetime drift is caused by etching of the pellicle in the presence of hydrogen plasma generated by the EUV exposure radiation.

Figure 4 is a plan view of a pellicle and reference mark arrangement in accordance with an embodiment of the invention. Pellicle MP extends across a region of the patterning device (not shown in the figure) that has a plurality of reference marks R1-R6. In this case there are six, but more or fewer may be employed in other circumstances. The reference marks R1-R6 may be patterning device alignment marks or other portions of the patterning device having known reflectivity. The reference marks may be regions of plain absorber. In regions of the pellicle MP corresponding to some, but not all, of the reference marks, the pellicle MP is provided with a protective coating 100. The regions provided with the protective coating 100 may be referred to as coated regions. In this example there are three coated regions, corresponding to reference marks R1, R2 and R6, but more or fewer may be employed in other cases. More coated regions allows for increased accuracy by averaging multiple measurements.

Protective coating 100 is provided to prevent adsorption and/or desorption of contaminants such as water that are absorbed onto uncoated regions of the pellicle when it is exposed to air. Protective coating 100 may comprise a layer of Ru, TiN or Al having a thickness in the range of 1 to 10 nm, e.g. 5 nm. Other materials known for use as capping layers on pellicles may also be used. Because of the protective coating, coated regions do not suffer, or suffer to a lesser extent, from mechanisms that cause a change in transmission of the pellicle. For example, the protective coating may prevent absorption of water when the reticle and pellicle are not in the lithographic apparatus, hence there is not a change in transmission due to desorption of water. For example, the protective coating may protect the pellicle from etching by hydrogen plasma or hydrogen radicals generated by the EUV exposure radiation.

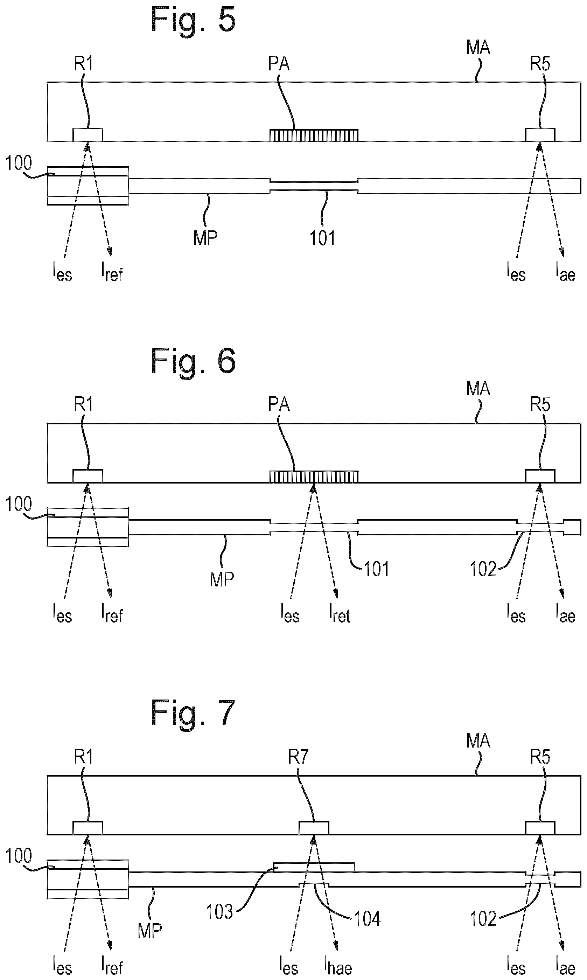

Figure 5 is a cross sectional view of the reticle MA and pellicle MP showing two reference marks R1, R5 and the pattern area PA. The region of the pellicle MP is provided with a protective coating 100 on both sides thereof. Protective coating 100 prevents etching of the pellicle MP when the exposure radiation is active and hence pellicle MP is thicker in the region covered by protective coating 100. By directing radiation of known intensity Iₑₛ through pellicle MP to reflect off a reference mark R1, etc., and measuring the intensity Iₐₑ, I_{ref} of the reflected radiation after it has again passed through the pellicle, it is possible to determine the transmission of the pellicle. Measurements are taken at multiple times and at reference marks where the pellicle is provided with a protective coating and where it is not, in order to determine changes of the transmission of the pellicle over time and to distinguish between different causes of change in the transmission of the pellicle.

Transmission of the pellicle in a coated region, T_{ref}, may be defined as follows: ${T}_{ref} = {T}_{pel} \times {T}_{cap}^{2} = \sqrt{\frac{{I}_{ref}}{{I}_{es}}}$ where Tₚₑₗ is the transmission of the pellicle T_{cap} is the transmission of one capping layer (if the capping layers on the two sides are of different thicknesses or materials T_{cap}² can be replaced by T_{cap1} x T_{cap2}). Iₑₛ is the intensity of the incident radiation and I_{ref} is the measured intensity after two passes through the pellicle MP and protective coatings.

Transmission of the pellicle in the uncoated region 102, Tₐₑ, may be defined as: ${T}_{ae} = \sqrt{\frac{{I}_{ae}}{{I}_{es}}}$ where Iₐₑ, is the measured intensity after two passes through the pellicle in the uncoated region 102 that is affected by etching, or other causes of transmission change.

Of course some other factors may affect the above measurements, such as variations in the reflectivity of the reference marks and/or the intensity of the radiation source used. If errors introduced by such effects are non-negligible they can be compensated for, e.g. by performing multiple measurements and averaging. Variations in the reflectivity of the reference marks may be measured in advance and stored in a database.

The measured transmissions may be used to control the lithographic apparatus in several ways. For example, it is possible to monitor changes in Tₐₑ relative to T_{ref} in order to determined whether the pellicle transmission is in the fast initial drift phase or the lifetime slow drift phase. Discrimination between phases may be performed based on a threshold or by fitting measurements to a suitable function, e.g. an exponential. A calculation of an adjustment to the power of the exposure radiation may be based on the determination of whether the pellicle transmission is in the fast initial drift phase or the lifetime slow drift phase. By more accurately predicting, and compensating for, the transmission of the pellicle in the fast initial drift phase, throughput and/or yield of the lithographic apparatus may be improved.

The inventors have noticed that the increase of the transmission of the pellicle may occur more quickly in an uncoated region 101 corresponding to the pattern area of the reticle than in the uncoated region 102 corresponding to the reference mark R5. This may be because the increase in transmission is driven by hydrogen radical or plasma etching and hydrogen radicals or plasma are generated by the exposure radiation which is present more often and/or at greater intensity in the pattern area than at the location of the reference marks. A correction factor to account for this difference may therefore be applied in determining the exposure dose to be applied. A suitable value for the correction factor may be determined empirically, e.g. by FEM or CD measurements.

The ratio Tₐₑ/T_{ref} may also be used to monitor the lifetime of a pellicle. If the transmission of the pellicle becomes very high, this may mean that the pellicle has become very thin, and might be in danger of rupture. Therefore a threshold may be set for the ratio Tₐₑ/T_{ref} and the pellicle replaced if it is exceeded. Prediction of the lifetime of the pellicle is advantageous because rupture of the pellicle in situ may result in damage to the reticle and/or particle being deposited on the reticle or in the lithographic apparatus.

Figure 6 is a cross sectional view of the reticle MA and pellicle MP showing two reference marks R1, R5 and the pattern area PA to illustrate a development of the above method. In addition to the measurements described above, the transmission, Tᵣₑₜ of the pellicle in the uncoated region 101 corresponding to the pattern area PA is measured as: ${T}_{ret} = \sqrt{\frac{{I}_{ret}}{{I}_{es}}}$ where Iᵣₑₜ is the intensity of the radiation reflected by a predefined region in the pattern area of the reticle. It is noted that Tᵣₑₜ may need to be corrected by a factor relating the reflectivity of the reticle, which may vary depending on the pattern formed therein. Reticle reflectivity may be measured during manufacture of the reticle and can be assumed not to vary substantially with time.

Measurement of Tᵣₑₜ, in addition to T_{ref} and Tₐₑ, at multiple points in time provides additional information to distinguish between transmission changes due to desorption of contamination and long term etching and avoids the need to experimentally determine a correction factor to account for the different etching rate between the regions of the pellicle corresponding to the pattern area of the reticle MA and to the reference marks. A more accurate correction to exposure dose and a more accurate prediction of pellicle lifetime can therefore be obtained.

Figure 7 is a cross sectional view of the reticle MA and pellicle MP showing three reference marks R1, R5, R7 to illustrate another development of the above method. As depicted in Figure 7, the pellicle MP is provided with a protective coating 103 only on one side thereof in the region corresponding to reference mark R7. Accordingly, the pellicle MP is etched during use to a lesser degree than uncoated areas so that there is a partially thinned area 104. The one-side coated region may also be subject to short-term transmission changes to a lesser degree than the uncoated regions but a greater degree than two-side coated regions. Measurements from the one-side coated region can therefore provide additional information to distinguish between transmission changes due to different causes.

With the unetched pellicle transmission Tpel and capping layer transmission Tcap known from the design, two equations with two unknowns; absorption and etching, can be derived and solved, assuming single pass: ${T}_{hae} = {T}_{cap} \times \left(1-\frac{etch}{2}\right) \times \left({T}_{abs}\times {T}_{pel}\right)$ ${T}_{ae} = \left(1-etch\right) \times \left({T}_{abs}\times {T}_{pel}\right)$

It will be appreciated that although the one-side protective coating is show as being on the reticle-facing side of the pellicle, it may instead be provided on the opposite side of the pellicle. Whilst only a single region having a one-side protective coating is shown, there may of course be a plurality of regions having a one-side protective coating. A one-side protective coating may of course be used in a method involving measurement if transmission in the region corresponding to the pattern area, as discussed with reference to Figure 6.

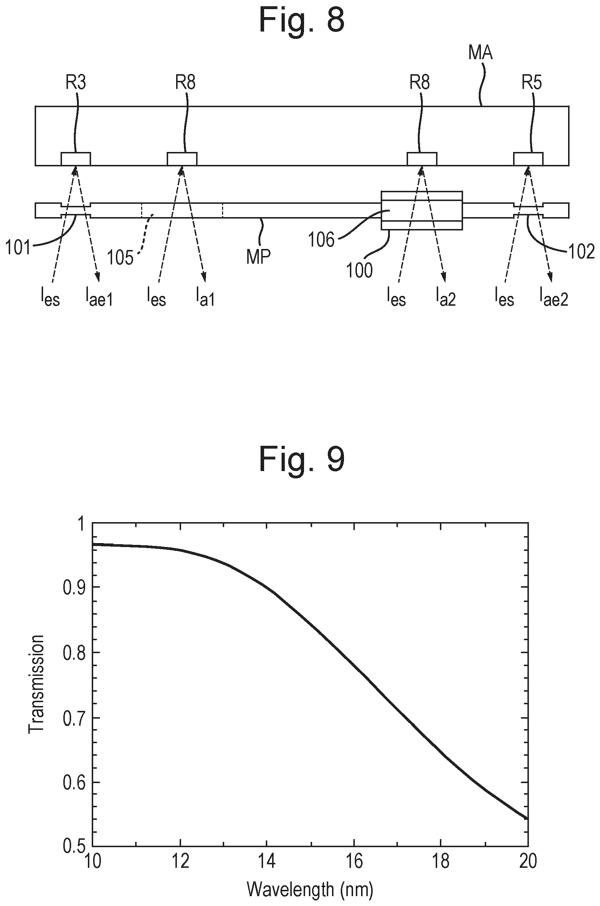

Figure 8 is a cross sectional view of the reticle MA and pellicle MP showing four reference marks R1, R8, R7, R8 to illustrate another development of the above method. In the arrangement of Figure 8, a low-use region 105 of the pellicle MP is protected from transmission change by being exposed to radiation much less often and/or at much lower intensity than regions of the pellicle corresponding to the pattern area PA. A reference mark R8 on the reticle MA corresponding to low-use region 105 is outside the pattern area PA. A doubly protected region 106 of the pellicle may be provided that is both low-use and provided with a protective coating 100 on one or both sides.

This arrangement enables measurement of transmission under at least four different conditions:
- Tₐₑ₁ : With short term absorption effect, with double sided long term etching by TIS mark exposure
- Tₐ₁ : With short term absorption effect, with no long term etching by TIS mark exposure (low use)
- Tₐ₂ : No short term absorption effect, no long term etching
- Tₐₑ₂ : With short term absorption effect, with double sided long term etching by TIS mark exposure

There is therefore additional information available to distinguish between and model different causes of transmission change. It is noted that the arrangements of Figure 7 and 8 assume that an effect on transmission is local to the regions of the pellicle through which the exposure radiation (EUV) passes and only occurs when then exposure radiation is active. This is believed to be the case for etching by hydrogen plasma or hydrogen radicals which are generated by the EUV radiation and quickly recombine outside the beam path and after the beam is switched off.

Figure 9 depicts the transmission of a 5 nm Ru capping layer for different wavelengths in the EUV range (10 - 20 nm). At 13.5 nm the transmission is about 95 % indicating the suitability of such a layer for a protective coating as used in the present invention.

The present method may be performed using various types of alignment sensors WS. For example, the alignment sensor WS may comprise a transmission image sensor (TIS). Detailed disclosure of TIS may be found in US 6888151 B2, WO 2022207259 A1 and WO 2017207512 A2, for example, all of which are incorporated herein by reference.

Additionally or alternatively, the alignment sensor WS may comprise a shearing interferometer phase-stepping measurement sensor (PARIS). Detailed disclosure of PARIS may be found in : WO 2021069147 A1, WO 2022248154 A1 and WO 2022268679 A1, all of which are incorporated herein by reference. Furthermore, each of the stage alignment mark MTF and the patterning device alignment mark MAF may comprise orthogonal gratings, for use with the PARIS.

In addition to a method of pellicle detection, there is also disclosed a method of manufacturing devices comprising the method of pellicle detection disclosed above.

There is also disclosed a computer program comprising instructions to cause a lithographic apparatus to perform the method of pellicle detection disclosed above.

There is also disclosed a lithographic apparatus configured to perform the method of pellicle detection disclosed above.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains one or multiple processed layers.

Although specific reference may have been made above to the use of embodiments of the invention in the context of optical lithography, it will be appreciated that the invention may be used in other applications.

Aspects of the invention are described in the following numbered clauses.
1. A method of measuring a pellicle mounted on a reticle in a lithographic apparatus, the method comprising:
   directing radiation through a measurement portion of the pellicle to a reflective portion of the reticle and measuring the intensity of reflected radiation to obtain a first detection intensity;
   directing radiation through a reference portion of the pellicle to a reflective portion of the reticle and measuring the intensity of reflected radiation to obtain a second detection intensity; and
   comparing the first and second detection intensities to obtain a measurement of a property of the pellicle;
   wherein the reference portion but not the measurement portion is protected against a cause of degradation of the pellicle.
2. The method of clause 1, wherein the reference portion comprises a coated region provided with a protective coating that is not present in the measurement portion.
3. The method of clause 2, wherein the coated region is provided with a protective coating on both sides thereof.
4. The method of clause 2 or 3, wherein the protective coating reduces or prevents adsorption of water into the pellicle.
5. The method of any one of clauses 2 to 4, wherein the protective coating comprises a layer of Ru, TiN or Al.
6. The method of any one of clauses 2 to 5, wherein the protective coating has a thickness in the range of from 1 to 10 nm.
7. The method of any one of clauses 1 to 6, wherein the reference portion comprises a low-use region that is outside a pattern area of the reticle and is only irradiated during measurement of the pellicle.
8. The method of clause 7, wherein the low-use region is provided with a protective coating on one or both sides thereof.
9. The method of any one of clauses 1 to 8, wherein the reflective portion of the reticle comprises a fiducial.
10. The method of any one of clauses 1 to 9, further comprising predicting a lifetime of the pellicle based on the measurement of a property.
11. The method of any one of clauses 1 to 10, wherein the property is transmission.
12. The method of any one of the preceding clauses, wherein the pellicle is made of a material that increases in transmission with the number of exposures.
13. The method of any one of the preceding clauses, wherein the pellicle is made of a carbon nanotube material.
14. A method of manufacturing devices comprising:
   measuring a property of a pellicle according to the method of any one of the preceding clauses; and
   controlling a dose of an exposure based on the measurement of a property.
15. A computer program comprising instructions to cause a lithographic apparatus to perform the method of clause 14 or 16.
16. A lithographic apparatus configured to perform the method of clause 14.
17. A pellicle for use in a lithographic apparatus, the pellicle comprising a measurement portion and a reference portion, wherein the reference portion but not the measurement portion is protected against a cause of degradation of the pellicle.
18. The pellicle of clause 17, wherein the reference portion comprises a coated region provided with a protective coating that is not present in the measurement portion.
19. The pellicle of clause 18, wherein the coated region is provided with a protective coating on both sides thereof.
20. The pellicle of clause 18 or 19, wherein the protective coating reduces or prevents adsorption of water into the pellicle.
21. The pellicle of any one of clauses 18 to 20, wherein the protective coating comprises a layer of Ru, TiN or Al.
22. The pellicle of any one of clauses 18 to 21, wherein the protective coating has a thickness in the range of from 1 to 10 nm.
23. A reticle for a lithographic process, the reticle having affixed thereto a pellicle according to any one of clauses 17 to 22.

While specific embodiments of the invention have been described above, it will be appreciated that the invention may be practiced otherwise than as described.

The descriptions above are intended to be illustrative, not limiting. Thus, it will be apparent to one skilled in the art that modifications may be made to the invention as described without departing from the scope of the claims set out below.

## Claims

1. A method of measuring a pellicle mounted on a reticle in a lithographic apparatus, the method comprising:
directing radiation through a measurement portion of the pellicle to a reflective portion of the reticle and measuring the intensity of reflected radiation to obtain a first detection intensity;
directing radiation through a reference portion of the pellicle to a reflective portion of the reticle and measuring the intensity of reflected radiation to obtain a second detection intensity; and
comparing the first and second detection intensities to obtain a measurement of a property of the pellicle;
wherein the reference portion but not the measurement portion is protected against a cause of degradation of the pellicle.

2. The method of claim 1, wherein the reference portion comprises a coated region provided with a protective coating that is not present in the measurement portion.

3. The method of claims 1 or 2, wherein the reference portion comprises a low-use region that is outside a pattern area of the reticle and is only irradiated during measurement of the pellicle.

4. The method of claim 3, wherein the low-use region is provided with a protective coating on one or both sides thereof.

5. The method of any one of claims 1 to 4, wherein the reflective portion of the reticle comprises a fiducial.

6. The method of any one of claims 1 to 5, further comprising predicting a lifetime of the pellicle based on the measurement of a transmission.

7. The method of any one of the preceding claims, wherein the pellicle is made of a material that increases in transmission with the number of exposures.

8. The method of any one of the preceding claims, wherein the pellicle is made of a nanotube material.

9. A method of manufacturing devices comprising:
measuring a property of a pellicle according to the method of any one of the preceding claims; and
controlling a dose of an exposure based on the measurement of a property.

10. A pellicle for use in a lithographic apparatus, the pellicle comprising a measurement portion and a reference portion, wherein the reference portion but not the measurement portion is protected against a cause of degradation of the pellicle.

11. The pellicle of claim 10, wherein the reference portion comprises a coated region provided with a protective coating that is not present in the measurement portion.

12. The pellicle of claim 11, wherein the coated region is provided with a protective coating on both sides thereof.

13. The pellicle of claim 11 or 12, wherein the protective coating reduces or prevents adsorption of water into the pellicle.

14. The pellicle of any one of claims 11 to 13, wherein the protective coating comprises a layer of Ru, TiN or Al.

15. The pellicle of any one of claims 11 to 14, wherein the protective coating has a thickness in the range of from 1 to 10 nm.
